# EUROPEAN PATENT SPECIFICATION

(11) **EP 3 324 428 B1**
(45) Date of publication and mention of the grant of the patent: **04.09.2019**
(21) Application number: 15898323.9
(22) Date of filing: 16.07.2015
(51) Int. Cl.: H01L 21/822, H01L 25/065, H01L 25/18, H01L 27/04, H04L 12/933

(54) **SEMICONDUCTOR SWITCH DEVICE**
HALBLEITERSCHALTVORRICHTUNG
DISPOSITIF COMMUTATEUR À SEMICONDUCTEURS

(43) Date of publication of application: 23.05.2018
(73) Proprietor: Pezy Computing K.K., Tokyo 101-0052 (JP)
(72) Inventor: SAITO, Motoaki, Tokyo 101-0052 (JP)
(74) Representative: Ström & Gulliksson AB
(86) International application number: PCT/JP2015/070450
(87) International publication number: WO 2017/010011

(56) References cited:
- JP-A- 2009 141 011
- JP-A- 2010 109 112
- JP-A- 2011 086 738
- JP-A- 2011 097 557
- JP-A- 2011 204 821
- JP-A- 2011 233 842
- US-A1- 2014 143 441
- TAKE YASUHIRO ET AL: "3D NoC with Inductive-Coupling Links for Building-Block SiPs", IEEE TRANSACTIONS ON COMPUTERS, IEEE, USA, vol. 63, no. 3, 1 March 2014 (2014-03-01), pages 748-763, XP011543912, ISSN: 0018-9340, DOI: 10.1109/TC.2012.249 [retrieved on 2014-03-26]

## Description

### TECHNICAL FIELD

The present invention relates to a semiconductor switch device.

### BACKGROUND ART

Conventionally, a switch chip in which the connection state between a plurality of input terminals and a plurality of output terminals can be changed is known (refer to Fig. 1 and [0021] of Patent Document 1). The switch chip of Patent Document 1 is configured by stacking a plurality of data switch chips.

Patent Document 1: Japanese Unexamined Patent Application, Publication No. 2006-114028

In TAKE YASUHIRO ET AL: "3D NoC with Inductive-Coupling Links for Building-Block SiPs", IEEE TRANSACTIONS ON COMPUTERS, IEEE, USA, val. 63, no. 3, 1 March 2014 (2014-03-01), pages 748-763, XP011543912, ISSN: 0018-9340, DOl: 10.11 09/TC.2012.249, a wireless NoC architecture is described. The architecture is used for building-block siPs, in which the number of hardware components (or chips) in a package can be changed after chips have been fabricated.

### DISCLOSURE OF THE INVENTION

### Problems to be Solved by the Invention

However, the switch chip configured by stacking the plurality of data switch chips requires a signal communication unit for signal communication between the data switch chips. In addition, the signal communication unit may be composed of a through-silicon via (TSV). However, the TSV may increase the size of the switch chip. In addition, the TSV may disturb integration of the switch chip.

It is an object of the present invention to provide a semiconductor switch device with a configuration that facilitates miniaturization and integration.

### Means for Solving the Problems

(1) The present invention relates to a semiconductor switch device. The semiconductor switch device includes: a semiconductor switch main body unit that has a plurality of semiconductor switch chips and a control unit which are layered;
   a plurality of first terminals that are connected to the semiconductor switch main body unit; and
   a plurality of second terminals that are connected to the semiconductor switch main body unit, the first terminals and the second terminals being connected via the semiconductor switch main body unit and a connection state between the first terminals and the second terminals being changed by the semiconductor switch main body unit so that a signal input from the first terminal being output from any one of the second terminals in a switchable manner, wherein each of the semiconductor switch chips has:
   a plurality of in-chip signal lines that can be connected with each other;
   a connection-state changing unit that changes the connection state between the plurality of in-chip signal lines according to an instruction from the control unit; and
   a plurality of non-contact communication units that are respectively connected to the plurality of in-chip signal lines,
   wherein each of the non-contact communication units of each of the semiconductor switch chips communicates with the non-contact communication units of one or more other semiconductor switch chips in a non-contact manner in a layering direction,
   wherein, in any given semiconductor switch chip, the first terminal and the second terminal are connected to any given in-chip signal line, and
   wherein the connection-state changing unit of each semiconductor switch chip changes the connection state between the plurality of in-chip signal lines according to the instruction from the control unit, so that the connection state between the plurality of first terminals and the plurality of second terminals is changed.
(2) One of the non-contact communication units of any given semiconductor switch chip may communicate, in a non-contact manner in the layering direction, with a non-contact communication unit of another semiconductor switch chip adjacent in the layering direction, the one of the non-contact communication units of the any given semiconductor switch chip being disposed to overlap in the layering direction with the non-contact communication unit of the another semiconductor switch chip.
(3) One of the non-contact communication units of any given semiconductor switch chip may communicate, in a non-contact manner in the layering direction, with a non-contact communication unit of another semiconductor switch chip that is not adjacent in the layering direction, the one of the non-contact communication units of the any given semiconductor switch chip being disposed to overlap in the layering direction with the non-contact communication unit of the another semiconductor switch chip.
(4) One of the non-contact communication units of any given semiconductor switch chip and one of the non-contact communication units of at least another semiconductor switch chip adjacent in the layering direction may not overlap each other in the layering direction.
(5) In the semiconductor switch chip, some non-contact communication units may be arranged to overlap the connection-state changing unit in the layering direction.
(6) The non-contact communication unit may be a coil.
(7) One of the non-contact communication units of any given semiconductor switch chip may be an adjacent communication non-contact communication coil that communicates, in a non-contact manner in the layering direction, with a non-contact communication unit of another semiconductor switch chip adjacent in the layering direction, the one of the non-contact communication units of the any given semiconductor switch chip being disposed to overlap in the layering direction with the non-contact communication unit of the another semiconductor switch chip,
   one of the non-contact communication units of any given semiconductor switch chip may be a non-adjacent communication non-contact communication coil that communicates, in a non-contact manner in the layering direction, with a non-contact communication unit of another semiconductor switch chip that is not adjacent in the layering direction, the one of the non-contact communication units of the any given semiconductor switch chip being disposed to overlap in the layering direction with the non-contact communication unit of the another semiconductor switch chip, and
   a magnetic flux density formed by the adjacent communication non-contact communication coil may be smaller than the magnetic flux density formed by the non-adjacent communication non-contact communication coil.

### Effects of the Invention

According to the present invention, it is possible to provide a semiconductor switch device with a configuration that facilitates miniaturization and integration.

### BRIEF DESCRIPTION OF THE DRAWINGS

Fig. 1 is a schematic diagram of a semiconductor switch device according to an embodiment of the present invention.
Fig. 2 is a schematic cross-sectional view explaining a configuration of the semiconductor switch device according to the embodiment of the present invention.
Fig. 3 is an exploded perspective view explaining the configuration of the semiconductor switch device according to the embodiment of the present invention.
Fig. 4 is an internal transparent perspective view of a semiconductor switch chip according to the embodiment of the present invention.
Fig. 5 is a schematic cross-sectional view explaining non-contact communication in the semiconductor switch device according to the embodiment of the present invention.

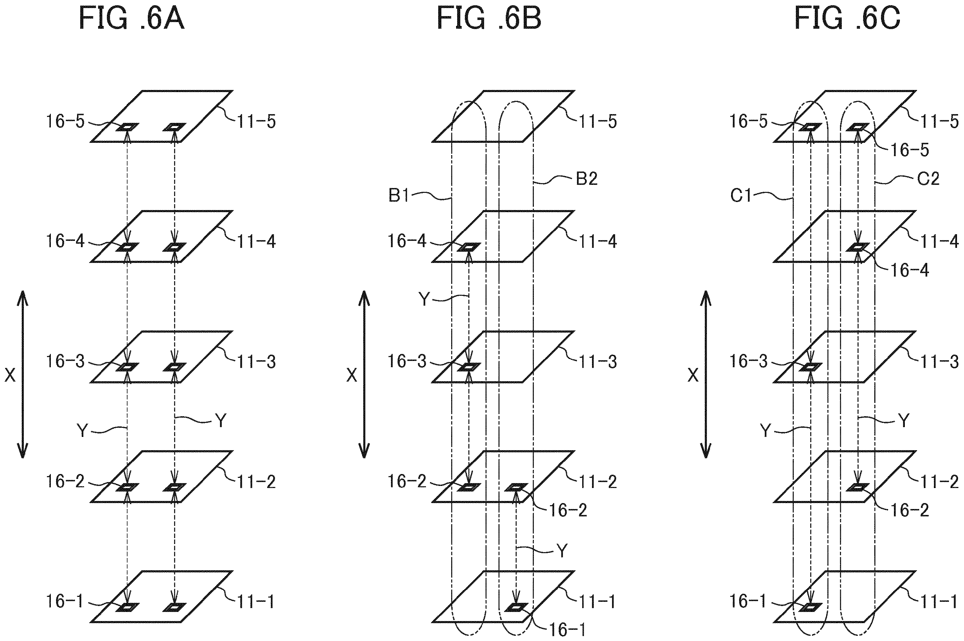

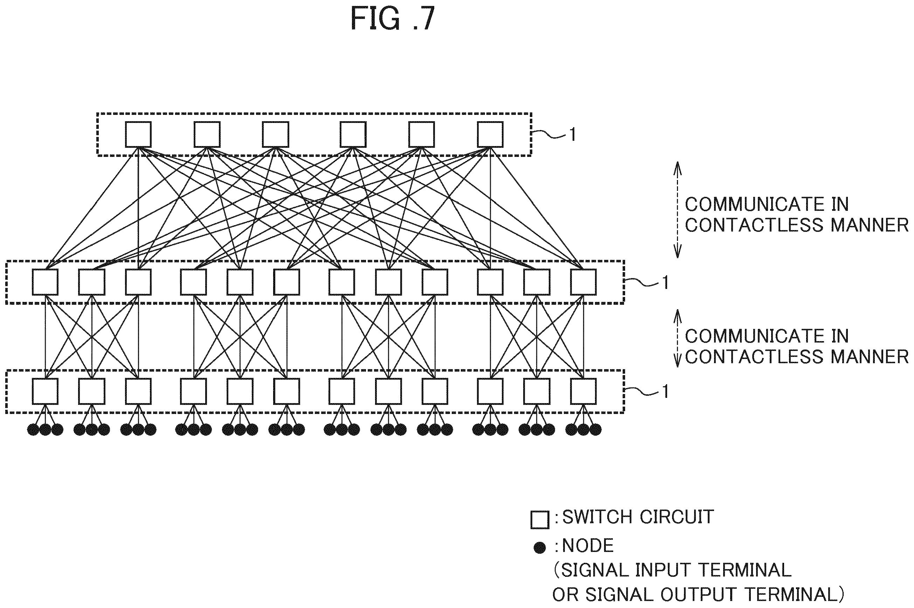

Figs. 6A to 6C are exploded perspective views explaining non-contact communication in the semiconductor switch device according to the embodiment of the present invention, in which Fig. 6A is a diagram showing an aspect where the non-contact communication is performed between all semiconductor switch chips, Fig. 6B is a diagram showing an aspect where the non-contact communication is performed between semiconductor switch chips adjacent to each other in a layering direction, and Fig. 6C is a diagram showing an aspect where the non-contact communication is performed between semiconductor switch chips not adjacent to each other in the layering direction. Fig. 7 shows a fat tree structure configured by the semiconductor switch device.

### PREFERRED MODE FOR CARRYING OUT THE INVENTION

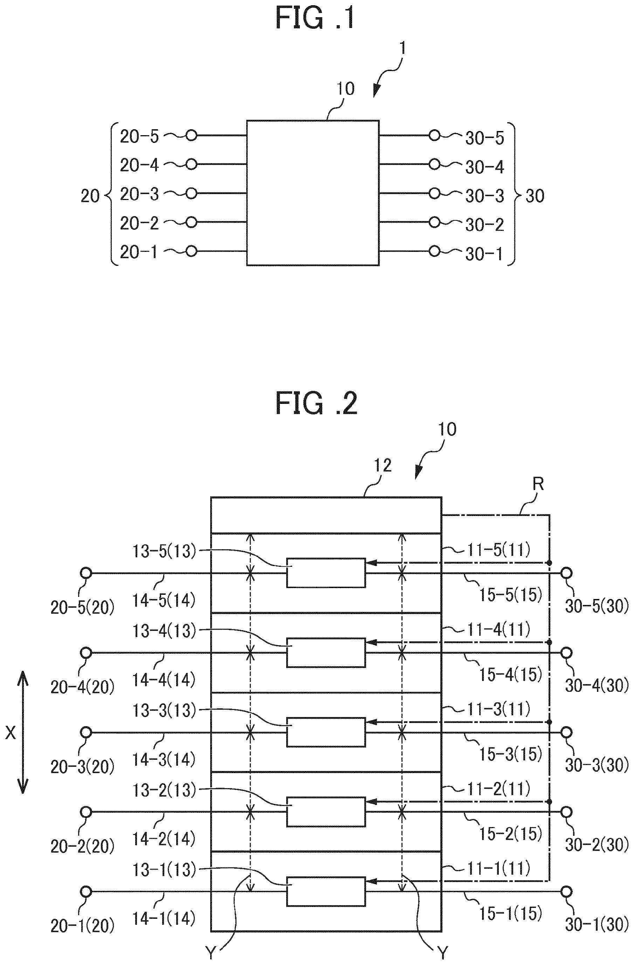

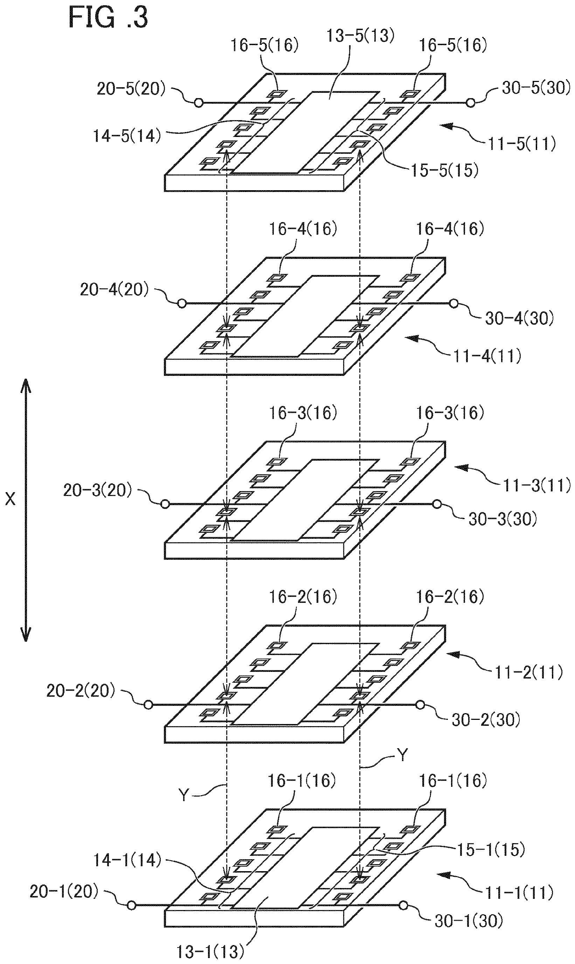

Hereinafter, an embodiment of the present invention will be described with reference to the drawings. Fig. 1 is a schematic diagram of a semiconductor switch device according to the embodiment of the present invention. Fig. 2 is a schematic cross-sectional view explaining the configuration of the semiconductor switch device according to the embodiment of the present invention. Fig. 3 is an exploded perspective view explaining the configuration of the semiconductor switch device according to the embodiment of the present invention.

In the following description, "performing communication in a non-contact manner" means that one communication unit performing the communication and another communication unit performing the communication perform the communication without contacting each other and using a conductive member (at least one of solder, a conductive adhesive, and a wire). In addition, "performing the communication in a contact manner" means that one communication unit performing the communication and another communication unit performing the communication perform the communication while contacting each other or perform the communication using a conductive member (at least one of a solder, a conductive adhesive, and a wire). In addition, the communication unit is a concept including a unit performing transmission and reception, a unit performing only the transmission, and a unit performing only the reception.

As shown in Figs. 1 and 2, a semiconductor switch device 1 includes a semiconductor switch main body unit 10, five (a plurality of) signal input terminals 20 functioning as first terminals, and five (a plurality of) signal output terminals 30 functioning as second terminals. The signal input terminals 20 include a first signal input terminal 20-1 to a fifth signal input terminal 20-5. The signal output terminals 30 include a first signal output terminal 30-1 to a fifth signal output terminal 30-5. The semiconductor switch device 1 is one independent device. The signal input terminals 20 and the signal output terminals 30 are terminals electrically connected to conductive units (conductive pads, electrodes, and the like) of a circuit board existing outside the semiconductor switch device 1. The signal input terminals 20 and the signal output terminals 30 are electrically connected to conductive units (conductive pads, electrodes, and the like) of the external circuit board or the like via conductive members such as solder or directly.

The five signal input terminals 20 are connected to the semiconductor switch main body unit 10. The five signal output terminals 30 are connected to the semiconductor switch main body unit 10. The five signal input terminals 20 and the five signal output terminals 30 can be connected via the semiconductor switch main body unit 10. In addition, the semiconductor switch main body unit 10 has a switching function as described later. Therefore, the semiconductor switch main body unit 10 can change the connection state between the five signal input terminals 20 and the five signal output terminals 30.

The semiconductor switch device 1 is mounted on a circuit board (not shown in the drawings) provided in an electronic apparatus (a computer, a communication device, or the like). In the semiconductor switch device 1, a signal input from the signal input terminal 20 to the semiconductor switch main body unit 10 is not always output to the specific signal output terminal 30, but is output to be switchable from any signal output terminal 30.

As shown in Fig. 2, the semiconductor switch main body unit 10 includes five (a plurality of) semiconductor switch chips 11 and a control chip 12 functioning as a control unit. The five (the plurality of) semiconductor switch chips 11 include a first semiconductor switch chip 11-1, a second semiconductor switch chip 11-2, a third semiconductor switch chip 11-3, a fourth semiconductor switch chip 11-4, and a fifth semiconductor switch chip 11-5. The first semiconductor switch chip 11-1 to the fifth semiconductor switch chip 11-5 are bonded to each other by fusion bonding and are layered. In addition, the control chip 12 is bonded to an upper part of the fifth semiconductor switch chip 11-5 by the fusion bonding and is layered on the fifth semiconductor switch chip 11-5.

As shown in Figs. 2 and 3, the first semiconductor switch chip 11-1 has a first switch circuit 13-1 functioning as a connection-state changing unit, first input-side signal lines 14-1 functioning as in-chip signal lines, first output-side signal lines 15-1 functioning as in-chip signal lines, and first non-contact communication coils 16-1 functioning as non-contact communication units. Likewise, the second semiconductor switch chip 11-2 to the fifth semiconductor switch chip 11-5 have a second switch circuit 13-2 to a fifth switch circuit 13-5 (connection-state changing units), second input-side signal lines 14-2 to fifth input-side signal lines 14-5 (in-chip signal lines), second output-side signal lines 15-2 to fifth output-side signal lines 15-5 (in-chip signal lines), and second non-contact communication coils 16-2 to fifth non-contact communication coils 16-5 (non-contact communication units). As such, the semiconductor switch chip 11 has switch circuits 13, input-side signal lines 14, output-side signal lines 15, and non-contact communication coils 16.

As shown in Fig. 3, the five (the plurality of) first input-side signal lines 14-1 are provided in the first semiconductor switch chip 11-1. Each of the five first input-side signal lines 14-1 is connected to the first switch circuit 13-1. One of the five (the plurality of) first input-side signal lines 14-1 is connected to the first signal input terminal 20-1.

Likewise, in the second semiconductor switch chip 11-2 to the fifth semiconductor switch chip 11-5, the second input-side signal line 14-2 to the fifth input-side signal line 14-5 are connected to the second switch circuit 13-2 to the fifth switch circuit 13-5, respectively. One of the five second input-side signal lines 14-2 is connected to the second signal input terminal 20-2. One of the five third input-side signal lines 14-3 is connected to the third signal input terminal 20-3. One of the five fourth input-side signal lines 14-4 is connected to the fourth signal input terminal 20-4. One of the five fifth input-side signal lines 14-5 is connected to the fifth signal input terminal 20-5.

The five (the plurality of) first output-side signal lines 15-1 are provided in the first semiconductor switch chip 11-1. Each of the five first output-side signal lines 15-1 is connected to the first switch circuit 13-1. One of the five first output-side signal lines 15-1 is connected to the first signal output terminal 30-1.

Likewise, in the second semiconductor switch chip 11-2 to the fifth semiconductor switch chip 11-5, the second output-side signal line 15-2 to the fifth output-side signal line 15-5 are connected to the second switch circuit 13-2 to the fifth switch circuit 13-5, respectively. One of the five first output-side signal lines 15-1 is connected to the first signal output terminal 30-1. One of the five second output-side signal lines 15-2 is connected to the second signal output terminal 30-2. One of the five third output-side signal lines 15-3 is connected to the third signal output terminal 30-3. One of the five fourth output-side signal lines 15-4 is connected to the fourth signal output terminal 30-4. One of the five fifth output-side signal lines 15-5 is connected to the fifth signal output terminal 30-5.

As shown in Fig. 3, the ten (the plurality of) first non-contact communication coils 16-1 to the ten (the plurality of) fifth non-contact communication coils 16-5 are provided in the first semiconductor switch chip 11-1 to the fifth semiconductor switch chip 11-5, respectively. In Fig. 3, an illustration of the control chip 12 is omitted. Each of the first non-contact communication coils 16-1 is connected to either the first input-side signal line 14-1 or the first output-side signal line 15-1. Each of the second non-contact communication coils 16-2 is connected to either the second input-side signal line 14-2 or the second output-side signal line 15-2. Each of the third non-contact communication coils 16-3 is connected to either the third input-side signal line 14-3 or the third output-side signal line 15-3. Each of the fourth non-contact communication coils 16-4 is connected to either the fourth input-side signal line 14-4 or the fourth output-side signal line 15-4. Each of the fifth non-contact communication coils 16-5 is connected to either the fifth input-side signal line 14-5 or the fifth output-side signal line 15-5.

As shown in Fig. 3, the first non-contact communication coil 16-1 to the fifth non-contact communication coil 16-5 are arranged to overlap each other in a layering direction X. In the first non-contact communication coil 16-1 to the fifth non-contact communication coil 16-5, non-contact communication is enabled between the coils overlapping each other in the layering direction X. For example, the first non-contact communication coil 16-1 can communicate with the second non-contact communication coil 16-2 overlapping the first non-contact communication coil 16-1 in the layering direction X in a non-contact manner, as shown by the dotted arrows Y of Figs. 2 and 3. Likewise, the first non-contact communication coil 16-1 to the fifth non-contact communication coil 16-5 can communicate with each other in a non-contact manner, as shown by the dotted arrows Y. From the different viewpoint, the first non-contact communication coil 16-1 to the fifth non-contact communication coil 16-5 can communicate with each other in a non-contact manner in an overlapping direction in the layering direction X by inductive coupling generated between the individual coils.

As shown in Fig. 2, the control chip 12 outputs an instruction signal R (one-dotted chain line in FIG. 2) as an instruction to each of the first switch circuit 13-1 to the fifth switch circuit 13-5. The first switch circuit 13-1 changes the connection state between the first input-side signal line 14-1 and the first output-side signal line 15-1, on the basis of the instruction signal R from the control chip 12. Therefore, a signal input from each first input-side signal line 14-1 can be output from any first output-side signal line 15-1 via the first switch circuit 13-1. Each of the second switch circuit 13-2 to the fifth switch circuit 13-5 also performs the same operation on the basis of the instruction signal R from the control chip 12. Therefore, a signal input from each second input-side signal line 14-2 can be output from any second output-side signal line 15-2 via the second switch circuit 13-2. A signal input from each third input-side signal line 14-3 can be output from any third output-side signal line 15-3 via the third switch circuit 13-3. A signal input from each fourth input-side signal line 14-4 can be output from any fourth output-side signal line 15-4 via the fourth switch circuit 13-4. A signal input from each fifth input-side signal line 14-5 can be output from any fifth output-side signal line 15-5 via the fifth switch circuit 13-5.

Next, an operation of the semiconductor switch device 1 will be described with reference to Figs. 2 and 3. Here, an example of an operation in the case where a signal S1 input to the first signal input terminal 20-1 is output to the fifth signal output terminal 30-5 will be described.

The signal S1 input to the first signal input terminal 20-1 is input to the fifth switch circuit 13-5 via the first input-side signal line 14-1, the first non-contact communication coil 16-1, the second non-contact communication coil 16-2, the third non-contact communication coil 16-3, the fourth non-contact communication coil 16-4, the fifth non-contact communication coil 16-5, and the fifth input-side signal line 14-5.

The fifth switch circuit 13-5 changes the connection state such that the fifth input-side signal line 14-5 to which the signal S1 is input and the fifth output-side signal line 15-5 connected to the fifth signal output terminal 30-5 output-side signal line 15-5 are connected to each other according to the instruction signal R from the control chip 12. As a result, the signal S1 is output from the fifth signal output terminal 30-5 via the fifth output-side signal line 15-5.

In addition, the signal S1 input to the first signal input terminal 20-1 can be output from the fifth signal output terminal 30-5 via the following path. For example, after the signal S1 input to the first signal input terminal 20-1 is output to the first output-side signal line 15-1 via the first switch circuit 13-1 in the first semiconductor switch chip 11-1, the signal S1 can be output from the fifth signal output terminal 30-5 via the first non-contact communication coil 16-1 to the fifth non-contact communication coil 16-5. In addition, after the signal S1 input to the first signal input terminal 20-1 is output to the second output-side signal line 15-2 via the first non-contact communication coil 16-1, the second non-contact communication coil 16-2, and the second switch circuit 13-2, the signal S1 can be output from the fifth signal output terminal 30-5 via the third non-contact communication coil 16-3 to the fifth non-contact communication coil 16-5.

In addition to the description given here, the signal S1 input to the first signal input terminal 20-1 can be output from the fifth signal output terminal 30-5 via various paths (paths configured using the switch circuit 13, the input-side signal line 14, the output-side signal line 15, the non-contact communication coil 16, and the like). In addition, the signal S1 input to the first signal input terminal 20-1 can be output from any one of the first signal output terminal 30-1 to the fourth signal output terminal 30-4 via the various paths. Likewise, the signals input from the second signal input terminal 20-2 to the fifth signal input terminal 20-5 can be output from any one of the first signal output terminal 30-1 to the fifth signal output terminal 30-5 via various paths.

As such, the connection states between the first signal input terminal 20-1 to the fifth signal input terminal 20-5 and the first signal output terminal 30-1 to the fifth signal output terminal 30-5 are changed by the semiconductor switch main body unit 10. Therefore, the semiconductor switch device 1 functions as a switch device in which the signal input from each of the first signal input terminal 20-1 to the fifth signal input terminal 20-5 can be output from any one of the first signal output terminal 30-1 to the fifth signal output terminal 30-5.

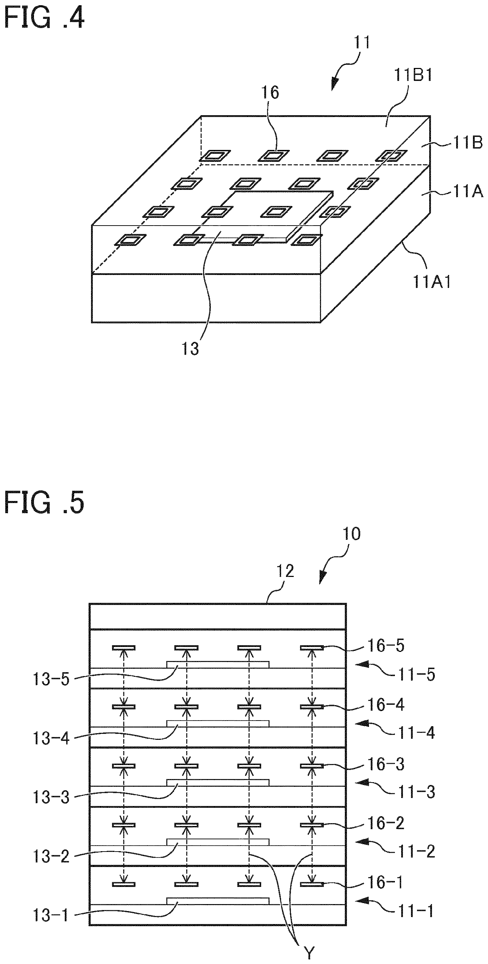

Positions, numbers, shapes, and the like of the switch circuits 13, the input-side signal lines 14, the output-side signal lines 15, and the non-contact communication coils 16 in Fig. 3 are different from those in Figs. 4 and 5 to be described later. This is because Fig. 3 is a diagram simplified to facilitate the description of the communication between the semiconductor switch chips 11 and is not a diagram showing actual positions, actual numbers, and the like of the switch circuits 13, the input-side signal lines 14, the output-side signal lines 15, and the non-contact communication coils 16.

Next, a structure of the semiconductor switch chip 11 (the first semiconductor switch chip 11-1 to the fifth semiconductor switch chip 11-5) will be described with reference to Figs. 4 and 5.

As shown in Fig. 4, the semiconductor switch chip 11 includes a semiconductor substrate unit 11A and an insulating layer unit 11B. The switch circuit 13 is formed on the semiconductor substrate unit 11A. The insulating layer unit 11B is layered (disposed) on the semiconductor substrate unit 11A to cover the semiconductor substrate unit 11A and the switch circuit 13. The plurality of non-contact communication coils 16 functioning as the non-contact communication units are formed in the insulating layer unit 11B. Each non-contact communication coil 16 is connected to the input-side signal line 14 (not shown in the drawings) or the output-side signal line 15 (not shown in the drawings) in the insulating layer unit 11B. Some of the plurality of non-contact communication coils 16 are arranged to overlap the switch circuits 13 in the layering direction X. Therefore, the size of the region needed to arrange the non-contact communication coils 16 can be reduced.

The semiconductor substrate unit 11A is a substrate that is made of silicon. The insulating layer unit 11B is made of silicon oxide. The semiconductor switch chip 11 has a semiconductor substrate unit principal surface 11A1 of the semiconductor substrate unit 11A on which the insulating layer unit 11B is not layered (disposed) and an insulating layer unit principal surface 11B1 being a surface of the insulating layer unit 11B. As shown in Fig. 5, the semiconductor substrate unit principal surface 11A1 of one semiconductor switch chip 11 and the insulating layer unit principal surface 11B1 of another semiconductor switch chip 11 adjacent to one semiconductor switch chip 11 in the layering direction are bonded by fusion bonding, so that the five semiconductor switch chips 11 are layered. As such, the five semiconductor switch chips 11 are directly bonded and are layered without gaps.

In Fig. 5, an illustration of the first signal input terminal 20-1 to the fifth signal input terminal 20-5 and the first signal output terminal 30-1 to the fifth signal output terminal 30-5 is omitted. The first signal input terminal 20-1 to the fifth signal input terminal 20-5 and the first signal output terminal 30-1 to the fifth signal output terminal 30-5 may be provided, for example, on the semiconductor substrate unit principal surface 11A1 of the first semiconductor switch chip 11-1 or a surface of the control chip 12. In this case, for example, the first signal input terminal 20-1 to the fifth signal input terminal 20-5 and the first signal output terminal 30-1 to the fifth signal output terminal 30-5 are each connected to the first switch circuit 13-1 to the fifth switch circuit 13-5 via penetration electrodes or non-contact communication coils, respectively. In addition, the first signal input terminal 20-1 to the fifth signal input terminal 20-5 and the first signal output terminal 30-1 to the fifth signal output terminal 30-5 may be provided, for example, on the insulating layer unit principal surface 11B1 of the fifth semiconductor switch chip 11-5. In this case, for example, the first signal input terminal 20-1 to the fifth signal input terminal 20-5 and the first signal output terminal 30-1 to the fifth signal output terminal 30-5 are each connected to the first switch circuit 13-1 to the fifth switch circuit 13-5 via penetration electrodes or non-contact communication coils, respectively. In addition, the control chip 12 is disposed on a part (for example, the semiconductor substrate unit main surface 11A1 of the first semiconductor switch chip 11-1) other than the insulating layer unit main surface 11B1 of the fifth semiconductor switch chip 11-5. In addition, the first signal input terminal 20-1 to the fifth signal input terminal 20-5 and the first signal output terminal 30-1 to the fifth signal output terminal 30-5 may be provided, for example, on a side surface of the semiconductor switch main body unit.

The total thickness of the semiconductor substrate unit 11A and the insulating layer unit 11B is, for example, 2 µm to 25 µm. As such, because each of the semiconductor switch chips 11 is formed thinly, the thickness of the semiconductor switch chips 11 is only about 256 µm to 3200 µm even if the semiconductor switch chips 11 are layered in 128 layers. Therefore, the semiconductor switch chip 11 facilitates miniaturization and integration of the semiconductor switch device 1.

The input-side signal line 14 (not shown in the drawings), the output-side signal line 15 (not shown in the drawings), and the non-contact communication coil 16 are formed of copper, aluminum, or the like. Each non-contact communication coil 16 has the same size, for example, 5 µm to 100 µm. Therefore, a large number of non-contact communication coils 16 can be arranged in one semiconductor switch chip 11. Therefore, the semiconductor switch chip 11 facilitates the miniaturization and the integration of the semiconductor switch device 1.

The input-side signal line 14, the output-side signal line 15, and the non-contact communication coil 16 can be formed by known wiring formation technology (wiring formation technology using a damascene method, wiring formation technology using sputtering and etching, or the like). Therefore, a wiring formation process for connection between chips in the following processes can be simplified.

As described above, the non-contact communication coil 16 is arranged to overlap the switch circuit 13 in the layering direction X. Therefore, the first semiconductor switch chip 11-1 to the fifth semiconductor switch chip 11-5 communicate with each other via the facing non-contact communication coils 16.

As shown by the dotted arrows Y of Fig. 5, at least a part of the communication using the facing non-contact communication coils 16 is performed via the semiconductor substrate unit 11A, the switch circuit 13, and the insulating layer unit 11B. Such communication is peculiar to communication using the non-contact communication coils 16 and cannot be realized by TSV.

In the above description, the first non-contact communication coil 16-1 to the fifth non-contact communication coil 16-5 are arranged to overlap each other in the layering direction X. In this aspect, the non-contact communication coil 16 of each semiconductor switch chip 11 can communicate with the non-contact communication coils 16 of all the other semiconductor switch chips 11 in a non-contact manner in the layering direction X.

However, there are various aspects in the communication of the non-contact communication coils 16. The various aspects will be described with reference to Fig. 6. Figs. 6A to 6C are exploded perspective views explaining non-contact communication in the semiconductor switch device according to the embodiment of the present invention. Fig. 6A is a diagram showing an aspect where the non-contact communication is performed between all semiconductor switch chips. Fig. 6B is a diagram showing an aspect where the non-contact communication is performed between semiconductor switch chips adjacent to each other in a layering direction. Fig. 6C is a diagram showing an aspect where the non-contact communication is performed between semiconductor switch chips not adjacent to each other in the layering direction.

As shown in Fig. 6A, the non-contact communication coil 16 of the semiconductor switch chip 11 can communicate with the non-contact communication coils 16 of all the other semiconductor switch chips 11 in a non-contact manner. This arrangement is the same arrangement as the arrangement described above. In this arrangement, one of the non-contact communication coils 16 in all of the semiconductor switch chips 11 is arranged to overlap each other in the layering direction X. The non-contact communication coils 16 in Fig. 6A communicate with the non-contact communication coils, which are the non-contact communication coils 16 of the semiconductor switch chips 11 adjacent in the layering direction and are overlapped in the layering direction, in a non-contact manner in the layering direction. Such non-contact communication coils 16 may be referred to as adjacent communication non-contact communication coils.

As shown in Figs. 6B and 6C, the non-contact communication coils 16 of the semiconductor switch chips 11 can be arranged to communicate with the non-contact communication coils 16 of some of the other semiconductor switch chips 11 in a non-contact manner. In this arrangement, at least one non-contact communication coil 16 of the non-contact communication coils 16 in some semiconductor switch chips 11 is arranged to overlap each other in the layering direction X and is arranged so as not to overlap the non-contact communication coils 16 in other semiconductor switch chips 11 different from some semiconductor switch chips 11.

In the aspect shown in Fig. 6B, the non-contact communication coil 16 of the semiconductor switch chip 11 can communicate with the non-contact communication coil 16 of another semiconductor switch chip 11 adjacent in the layering direction X in a non-contact manner. The non-contact communication coils 16 of the semiconductor switch chips 11 not adjacent to each other cannot communicate with each other in a non-contact manner. The non-contact communication coils 16 of the semiconductor switch chips 11 adjacent to each other are arranged to overlap each other in regions (B1 and B2) extending in the layering direction X. In addition, the non-contact communication coils 16 of the semiconductor switch chips 11 not adjacent to each other are not arranged to overlap each other in the regions (B1 and B2) extending in the layering direction X.

For example, in Fig. 6B, the third semiconductor switch chip 11-3 is adjacent to the second semiconductor switch chip 11-2 and the fourth semiconductor switch chip 11-4 in the layering direction X. In addition, the non-contact communication coil 16-3 of the third semiconductor switch chip 11-3 is arranged to overlap the non-contact communication coil 16-2 of the second semiconductor switch chip 11-2 and the non-contact communication coil 16-4 of the fourth semiconductor switch chip 11-4 in the region B1 (two-dotted chain line) extending in the layering direction X. Therefore, the non-contact communication coil 16-3 of the third semiconductor switch chip 11-3 can communicate with the non-contact communication coil 16-2 of the second semiconductor switch chip 11-2 and the non-contact communication coil 16-4 of the fourth semiconductor switch chip 11-4 in a non-contact manner in the layering direction X in the region B1.

On the other hand, the third semiconductor switch chip 11-3 is not adjacent to the first semiconductor switch chip 11-1 and the fifth semiconductor switch chip 11-5. In addition, the first non-contact communication coil 16-1 of the first semiconductor switch chip 11-1 and the fifth non-contact communication coil 16-5 of the fifth semiconductor switch chip 11-5 are not arranged to overlap the non-contact communication coil 16-3 of the third semiconductor switch chip 11-3 in the region B1. Therefore, the non-contact communication coil 16-3 of the third semiconductor switch chip 11-3 cannot communicate with the first non-contact communication coil 16-1 of the first semiconductor switch chip 11-1 and the fifth non-contact communication coil 16-5 of the fifth semiconductor switch chip 11-5 in a non-contact manner in the layering direction X in the region B1.

For example, in Fig. 6B, the second semiconductor switch chip 11-2 is adjacent to the first semiconductor switch chip 11-1 in the layering direction X. In addition, the non-contact communication coil 16-2 of the second semiconductor switch chip 11-2 is arranged to overlap the first non-contact communication coil 16-1 of the first semiconductor switch chip 11-1 in the region B2 (two-dotted chain line) extending in the layering direction X. Therefore, the second non-contact communication coil 16-2 of the second semiconductor switch chip 11-2 can communicate with the first non-contact communication coil 16-1 of the first semiconductor switch chip 11-1 in a non-contact manner in the layering direction X in the region B2.

On the other hand, the second semiconductor switch chip 11-2 is not adjacent to the fourth semiconductor switch chip 11-4 and the fifth semiconductor switch chip 11-5. In addition, the fourth non-contact communication coil 16-4 of the fourth semiconductor switch chip 11-4 and the fifth non-contact communication coil 16-5 of the fifth semiconductor switch chip 11-5 are not arranged to overlap the non-contact communication coil 16-2 of the second semiconductor switch chip 11-2 in the region B2. Therefore, the second non-contact communication coil 16-2 of the second semiconductor switch chip 11-2 cannot communicate with the fourth non-contact communication coil 16-4 of the fourth semiconductor switch chip 11-4 and the fifth non-contact communication coil 16-5 of the fifth semiconductor switch chip 11-5 in a non-contact manner in the layering direction X in the region B2.

The third semiconductor switch chip 11-3 is adjacent to the second semiconductor switch chip 11-2. Therefore, the third non-contact communication coil 16-3 of the third semiconductor switch chip 11-3 may be arranged to overlap the second non-contact communication coil 16-2 of the second semiconductor switch chip 11-2 in the region B2. However, it may not be arranged as shown in Fig. 6B.

In addition, the non-contact communication coils 16 in Fig. 6B communicate with the non-contact communication coils, which are the non-contact communication coils 16 of the semiconductor switch chips 11 adjacent in the layering direction and are overlapped in the layering direction, in a non-contact manner in the layering direction. Such non-contact communication coils 16 may be referred to as adjacent communication non-contact communication coils.

In the aspect shown in Fig. 6C, the non-contact communication coil 16 of the semiconductor switch chip 11 can communicate with the non-contact communication coil 16 of another semiconductor switch chip 11 not adjacent in the layering direction X in a non-contact manner via another adjacent semiconductor switch chip 11. The non-contact communication coils 16 of the semiconductor switch chips 11 adjacent to each other are arranged so as not to communicate with each other in a non-contact manner. The non-contact communication coils 16 of the semiconductor switch chips 11 not adjacent to each other are arranged to overlap each other in regions (C1 and C2 shown by two-dotted chain lines) extending in the layering direction X. In addition, the non-contact communication coils 16 of the semiconductor switch chips 11 adjacent to each other are not arranged to overlap each other in the regions (C1 and C2) extending in the layering direction X.

For example, in Fig. 6C, the third semiconductor switch chip 11-3 is not adjacent to the first semiconductor switch chip 11-1 and the fifth semiconductor switch chip 11-5. In addition, the third non-contact communication coil 16-3 of the third semiconductor switch chip 11-3 is arranged to overlap the first non-contact communication coil 16-1 of the first semiconductor switch chip 11-1 and the fifth non-contact communication coil 16-5 of the fifth semiconductor switch chip 11-5 in the region C1 (two-dotted chain line) extending in the layering direction X. Therefore, the third non-contact communication coil 16-3 of the third semiconductor switch chip 11-3 can communicate with the first non-contact communication coil 16-1 of the first semiconductor switch chip 11-1 and the fifth non-contact communication coil 16-5 of the fifth semiconductor switch chip 11-5 in a non-contact manner in the layering direction X in the region C1.

On the other hand, the third semiconductor switch chip 11-3 is adjacent to the second semiconductor switch chip 11-2 and the fourth semiconductor switch chip 11-4 in the layering direction. In addition, the second non-contact communication coil 16-2 of the second semiconductor switch chip 11-2 and the fourth non-contact communication coil 16-4 of the fourth semiconductor switch chip 11-4 are not arranged to overlap the third non-contact communication coil 16-3 of the third semiconductor switch chip 11-3 in the region C1. Therefore, the third non-contact communication coil 16-3 of the third semiconductor switch chip 11-3 cannot communicate with the second non-contact communication coil 16-2 of the second semiconductor switch chip 11-2 and the fourth non-contact communication coil 16-4 of the fourth semiconductor switch chip 11-4 in a non-contact manner in the layering direction X in the region C1.

For example, in Fig. 6C, the fourth semiconductor switch chip 11-4 is not adjacent to the second semiconductor switch chip 11-2 in the layering direction X. In addition, the fourth non-contact communication coil 16-4 of the fourth semiconductor switch chip 11-4 is arranged to overlap the second non-contact communication coil 16-2 of the second semiconductor switch chip 11-2 in the region C2 (two-dotted chain line) extending in the layering direction X. Therefore, the fourth non-contact communication coil 16-4 of the fourth semiconductor switch chip 11-4 can communicate with the second non-contact communication coil 16-2 of the second semiconductor switch chip 11-2 in a non-contact manner in the layering direction X in the region C2.

On the other hand, the fourth semiconductor switch chip 11-4 is adjacent to the third semiconductor switch chip 11-3. In addition, the fourth non-contact communication coil 16-4 of the fourth semiconductor switch chip 11-4 is not arranged to overlap the third non-contact communication coil 16-3 of the third semiconductor switch chip 11-3 in the region C2 extending in the layering direction X. Therefore, the fourth semiconductor switch chip 11-4 is not arranged to overlap the third non-contact communication coil 16-3 of the third semiconductor switch chip 11-3 in the region C2. Therefore, the fourth non-contact communication coil 16-4 of the fourth semiconductor switch chip 11-4 cannot communicate with the third non-contact communication coil 16-3 of the third semiconductor switch chip 11-3 in a non-contact manner in the layering direction X in the region C2.

The first semiconductor switch chip 11-1 is not adjacent to the fourth semiconductor switch chip 11-4. Therefore, the third non-contact communication coil 16-3 of the first semiconductor switch chip 11-1 may be arranged to overlap the fourth non-contact communication coil 16-4 of the fourth semiconductor switch chip 11-4 in the region C2. However, it may not be arranged as shown in Fig. 6C. The fifth semiconductor switch chip 11-5 is adjacent to the fourth semiconductor switch chip 11-4. Therefore, the fifth non-contact communication coil 16-5 of the fifth semiconductor switch chip 11-5 may be arranged so as not to overlap the fourth non-contact communication coil 16-4 of the fourth semiconductor switch chip 11-4 in the region C2. However, it may be arranged as shown in Fig. 6C.

In addition, the non-contact communication coils 16 in Fig. 6C communicate with the non-contact communication coils, which are the non-contact communication coils 16 of the semiconductor switch chips 11 not adjacent in the layering direction and are overlapped in the layering direction X, in a non-contact manner in the layering direction X. Such non-contact communication coils 16 may be referred to as non-adjacent communication non-contact communication coils.

The second non-contact communication coil 16-2 and the fourth non-contact communication coil 16-4 of Fig. 6B are adjacent communication non-contact communication coils and are also non-adjacent communication non-contact communication coils. The non-contact communication coil 16-4 of Fig. 6C serves not only as a non-adjacent communication non-contact communication coil but also as an adjacent communication non-contact communication coil.

As the arrangement of the non-contact communication coils 16, the arrangements shown in Figs. 6(A) to 6(C) may be mixed. That is, the non-contact communication coils 16 in a specific region extending in the layering direction X may communicate with the non-contact communication coils 16 of all the semiconductor switch chips 11 in the specific region, the non-contact communication coils 16 in another specific region extending in the layering direction X may communicate with only the non-contact communication coils 16 of the adjacent semiconductor switch chips 11, and the non-contact communication coils 16 in still another specific region extending in the layering direction X may communicate with only the non-contact communication coils 16 of the non-adjacent semiconductor switch chips 11.

In addition, each of the first non-contact communication coil 16-1 to the fifth non-contact communication coil 16-5 in Fig. 6A has been described as the adjacent communication non-contact communication coil. However, one or all of the first non-contact communication coil 16-1 to the fifth non-contact communication coil 16-5 may be adjacent communication non-contact communication coils and may also be non-adjacent communication non-contact communication coils. For example, the first non-contact communication coil 16-1 may communicate with the second non-contact communication coil 16-2 in a non-contact manner (that is, adjacent communication non-contact communication coil) and may communicate with the third non-contact communication coil 16-3 to the fifth non-contact communication coil 16-5 in a non-contact manner (that is, non-adjacent communication non-contact communication coil).

Figs. 1 to 6A, 6B, and 6C are diagrams simplified to facilitate understanding of the configuration and the operation of the present invention. The number of semiconductor switch chips 11 to be layered, the number and the arrangement of switch circuits 13, the number and the arrangement of each of input-side signal lines 14, output-side signal lines 15, and non-contact communication coils 16, the number and the arrangement of each of signal input terminals 20 and signal output terminals 30, and the like can be changed variously and Figs. 1 to 6 do not limit the present invention.

According to the semiconductor switch device 1 according to the embodiment that has the configuration described above, the following effects are achieved. The semiconductor switch device includes the semiconductor switch main body unit 10 that has the plurality of layered semiconductor switch chips 11 and the control chip 12, the plurality of signal input terminals 20 that are connected to the semiconductor switch main body unit 10, and the plurality of signal output terminals 30 that are connected to the semiconductor switch main body unit 10. Each of the signal input terminals 20 and each of the signal output terminals 30 can be connected via the semiconductor switch main body unit 10 and the connection state between each of the signal input terminals 20 and each of the signal output terminals 30 is changed by the semiconductor switch main body unit 10. In addition, each of the semiconductor switch chips 11 has the plurality of input-side signal lines 14 and the plurality of output-side signal lines 15 (the plurality of in-chip signal lines) that can be mutually connected, the switch circuit 13 that can change the connection state between the plurality of in-chip signal lines according to the instruction signal R from the control chip 12, and the plurality of non-contact communication coils 16 that are respectively connected to the plurality of input-side signal lines 14 and the plurality of output-side signal lines 15. Each non-contact communication coil of the semiconductor switch chip 11 can communicate with the non-contact communication coils 16 of one or more other semiconductor switch chips 11 in a non-contact manner in the layering direction, each signal input terminal 20 and each signal output terminal 30 are connected to any one of the plurality of input-side signal lines 14 and the plurality of output-side signal lines 15 of any semiconductor switch chip 11, and the switch circuit 13 of each semiconductor switch chip 11 changes the connection state between the plurality of input-side signal lines 14 and the plurality of output-side signal lines 15 according to the instruction signal R from the control chip 12, so that the connection state between each signal input terminal 20 and each signal output terminal 30 is changed.

Therefore, the semiconductor switch device 1 can realize a semiconductor switch device with a configuration that facilitates miniaturization and integration.

In addition, one non-contact communication coil 16 (for example, the non-contact communication coil 16 shown in Fig. 6A or 6B) of the semiconductor switch chip 11 communicates with the non-contact communication coils, which are the non-contact communication coils 16 of the semiconductor switch chips 11 adjacent in the layering direction and are overlapped in the layering direction, in a non-contact manner in the layering direction.

In addition, one non-contact communication coil 16 (for example, the third non-contact communication coil 16-3 of Fig. 6C) of the semiconductor switch chip 11 (for example, the third semiconductor switch chip 11-3 of Fig. 6C) communicates with the non-contact communication coils (for example, the first non-contact communication coil 16-1 and the fifth non-contact communication coil 16-5 of Fig. 6C), which are the non-contact communication coils of the semiconductor switch chips 11 (for example, the first semiconductor switch chip 11-1 and the fifth semiconductor switch chip 11-5 of Fig. 6C) not adjacent in the layering direction and are overlapped in the layering direction, in a non-contact manner in the layering direction.

In addition, one non-contact communication coil 16 (for example, the third non-contact communication coil 16-3 of Fig. 6C) of the semiconductor switch chip 11 (for example, the third semiconductor switch chip 11-3 of Fig. 6C) and the non-contact communication coils 16 (for example, the second non-contact communication coil 16-2 and the fourth non-contact communication coil 16-4 of Fig. 6C) of at least one semiconductor switch chip 11 (for example, at least one of the second semiconductor switch chip 11-2 and the fourth semiconductor switch chip 11-4 of Fig. 6C) adjacent in the layering direction do not overlap each other in the layering direction.

In addition, in the semiconductor switch chip 11, some non-contact communication coils are arranged to overlap the switch circuit 13 in the layering direction X.

As such, in each semiconductor switch chip 11, the non-contact communication coils 16 can be arranged in various aspects. Therefore, the semiconductor switch device 1 can realize a semiconductor switch device with a configuration that facilitates miniaturization and integration.

The embodiment of the present invention has been described. However, the present invention is not limited to the embodiment and various modifications can be made within a technical scope described in claims.

In this embodiment, the inductive coupling between the coils is used for non-contact signal transmission and reception. However, the present invention is not limited thereto. Magnetic resonance between coils may be used for the non-contact signal transmission and reception. In addition, cols may not be used for the non-contact signal transmission and reception. For example, an optical signal or a sound wave signal may be used.

In addition, in this embodiment, the signal input terminal 20 and the signal output terminal 30 are electrically connected to conductive units (conductive pads, electrodes, and the like) of a circuit board via conductive members such as solder or directly. However, the present invention is not limited thereto. Any one of the signal input terminal 20 and the signal output terminal 30 or both the signal input terminal 20 and the signal output terminal 30 may be non-contact communication units (non-contact communication coils) that can communicate with non-contact communication units (non-contact communication coils) of an external circuit board or the like in a non-contact manner.

In addition, in this embodiment, the difference of the characteristics of the individual non-contact communication coils 16 is not described. However, the characteristics of the individual non-contact communication coils 16 may be equal to each other or may be different from each other.

For example, the magnetic flux density formed by the adjacent communication non-contact communication coil may be smaller than the magnetic flux density formed by the non-adjacent communication non-contact communication coil. For example, the size of the adjacent communication non-contact communication coil may be smaller than the size of the non-adjacent communication non-contact communication coil. For example, the winding number (for example, the winding number of 2) of the non-adjacent communication non-contact communication coil may be larger than the winding number (for example, the winding number of 1) of the adjacent communication non-contact communication coil. In addition, a material (for example, ferrite, silicon oxide or silicon nitride mixed with ferrite, or the like) having a permeability higher than that of the material of the insulating layer unit 11B may be arranged in the vicinity of the center of the adjacent communication non-contact communication coil and a material having a permeability higher than that of the material of the insulating layer unit 11B may not be arranged in the vicinity of the center of the adjacent communication non-contact communication coil. This is because an output for inductive coupling can be relatively decreased in the adjacent communication non-contact communication coil, whereas it is necessary to relatively increase an output for induction in the non-adjacent communication non-contact communication coil.

In addition, in this embodiment, the case where the non-contact communication coil 16 is always activated has been described. However, the present invention is not limited thereto. A state changing circuit to change the state (active/inactive) of each non-contact communication coil 16 may be connected to the non-contact communication coil 16. The state changing circuit activates the non-contact communication coil 16 to be used and inactivates the non-contact communication coil 16 not to be used. If the state changing circuit activates the non-contact communication coil 16, the non-contact communication coil 16 enters a state where transmission and reception are enabled. If the state changing circuit inactivates the non-contact communication coil 16, the non-contact communication coil 16 enters a state where transmission and reception are disabled. In this embodiment, the switch circuit 13 was used as the connection-state changing unit. However, the switch circuit 13 and the state changing circuit may be used as the connection-state changing unit. In this case, the control chip 12 controls the switch circuit 13 and the state changing circuit.

In addition, in the aspect of Fig. 6B, the second non-contact communication coil 16-2 to the fourth non-contact communication coil 16-4 in the region B1 may communicate with the first semiconductor switch chip 11-1 or the fifth semiconductor switch chip 11-5. For example, at least one of the second semiconductor switch chip 11-2 to the fourth semiconductor switch chip 11-4 may communicate with the first semiconductor switch chip 11-1 or the fifth semiconductor switch chip 11-5 via the non-contact communication coils of another region connected by the wiring lines. The same is applied to the non-contact communication coils 16 of the region B2 of Fig. 6B and the regions C1 and C2 of Fig. 6C.

In addition, in this embodiment, some of the non-contact communication coils 16 are arranged to overlap the switch circuit 13 in the layering direction X. However, the present invention is not limited thereto. All the non-contact communication coils 16 may be arranged so as not to overlap the switch circuit 13.

In addition, in this embodiment, the semiconductor substrate unit 11A is a substrate made of silicon. However, the present invention is not limited thereto. The semiconductor substrate unit may be formed of a semiconductor material (for example, a compound semiconductor such as GaAs) other than silicon.

In addition, in this embodiment, the insulating layer unit 11B is made of silicon oxide. However, the present invention is not limited thereto. The insulating layer unit may be made of an insulating material (for example, silicon nitride or the like) other than silicon oxide and may be formed by layering two or more kinds of insulating material.

In addition, in this embodiment, fusion bonding is used as a bonding method. However, the present invention is not limited thereto. For example, the bonding method may be a method using an adhesive and may be a method of surface activated normal temperature bonding or the like.

Because the semiconductor switch device 1 has the configuration to facilitate integration, it is possible to configure a complicated switch structure with one semiconductor device. For example, conventionally, a huge switch chip on which a large number of phy and interconnection circuits are mounted is housed in a network switch mechanism. In large-scale systems or data centers, a considerable number of network switch mechanisms are combined and used in a fat tree structure. However, an enormous number of cables are needed to connect a considerable number of network switch mechanisms. On the other hand, in the semiconductor switch device 1 according to the present invention, each semiconductor switch chip 11 is thin and an occupancy area of each non-contact communication coil 16 is smaller than that of TSV or the like. Therefore, if the semiconductor switch device 1 according to the present invention is used for the network switch mechanism, the enormous number of cables in the large-scale systems or data centers can be reduced.

For example, the semiconductor switch device 1 can also be used for miniaturizing a network switch. The current network switch uses a large number of switch apparatuses, in some cases, hundreds of kilometers of cable, for connection between nodes. If this connection is realized in the chip using the non-contact communication units, a cableless network in which electrical connection is eliminated can be finally configured.

When the semiconductor switch device 1 is used, the entire system can be miniaturized at once and transmission delay, power consumption, and manufacturing cost can be greatly reduced. When it is thought that each coil used for the non-contact communication unit corresponds to a contact of a crossbar switch, it is possible to form a large number of contacts within a limited volume. For example, if semiconductors each having a thickness of 5 µm and a 10 mm square are layered in 128 layers, 100 million or more contacts can be formed with a thickness of 640 µm.

Fig. 7 shows a fat tree structure configured by the semiconductor switch device 1. By taking advantage of the integration, a network of a general fat tree configuration (a method of widening connection bandwidth of an upper layer in a tree-like network) shown in Fig. 7 can be constructed with the semiconductor switch devices 1 layered by the non-contact communication units. For example, a switch group of each layer surrounded by a broken line of Fig. 7 is the semiconductor switch device 1 and the semiconductor switch devices 1 are connected by the non-contact communication. Alternatively, there may be a configuration in which a plurality of switch devices 1 being collections of switches in upper, middle, and lower layers are prepared and these are connected to each other.

If multiple connections can be realized by these chips, the construction of a computer with a configuration close to a human brain comes into view. Nerve cells (neurons) that are referred to as operation elements of a brain are connected to other nerve cells at about 1000 contacts (synapses) per cell and it is said that 100 trillion to 200 trillion synaptic connections in the entire brain make human intelligence. In existing switch technology, it is impossible to realize such connections. However, if the non-contact communication units are used, the connections may be realized.

For example, the semiconductor switch device 1, an MIMD-type many-core processor, and the like are used, so that a function corresponding to a human cerebellum can be realized. The cerebellum plays a role of realizing smooth movement and posture maintenance on the basis of an input from sensory organs. Therefore, the semiconductor switch device 1, the MIMD-type many-core processor, and the like can be applied to a robot, an assist suit, a drone, and the like. In addition, the semiconductor switch device 1, the MIMD-type many-core processor, and the like can also be applied to artificial intelligence.

### EXPLANATION OF REFERENCE NUMERALS

1: semiconductor switch device
10: semiconductor switch main body unit
11: semiconductor switch chip
11A: semiconductor substrate unit
11A1: semiconductor substrate unit principal surface
11B: insulating layer unit
11B1: insulating layer unit principal surface
11-1: first semiconductor switch chip
11-2: second semiconductor switch chip
11-3: third semiconductor switch chip
11-4: fourth semiconductor switch chip
11-5: fifth semiconductor switch chip
12: control chip (control unit)
13: switch circuit (connection-state changing unit)
13-1: first switch circuit (connection-state changing unit)
13-2: second switch circuit (connection-state changing unit)
13-3: third switch circuit (connection-state changing unit)
13-4: fourth switch circuit (connection-state changing unit)
13-5: fifth switch circuit (connection-state changing unit)
14: input-side signal line
14-1: first input-side signal line
14-2: second input-side signal line
14-3: third input-side signal line
14-4: fourth input-side signal line
14-5: fifth input-side signal line
15: output-side signal line
15-1: first output-side signal line
15-2: second output-side signal line
15-3: third output-side signal line
15-4: fourth output-side signal line
15-5: fifth output-side signal line
16: non-contact communication coil (non-contact communication unit)
16-1: first non-contact communication coil (non-contact communication unit)
16-2: second non-contact communication coil (non-contact communication unit
16-3: third non-contact communication coil (non-contact communication unit
16-4: fourth non-contact communication coil (non-contact communication unit
16-5: fifth non-contact communication coil (non-contact communication unit
20: signal input terminal
20-1: first signal input terminal (first terminal)
20-2: second signal input terminal (first terminal)
20-3: third signal input terminal (first terminal)
20-4: fourth signal input terminal (first terminal)
20-5: fifth signal input terminal (first terminal)
30: signal output terminal
30-1: first signal output terminal (second terminal)
30-2: second signal output terminal (second terminal)
30-3: third signal output terminal (second terminal)
30-4: fourth signal output terminal (second terminal)
30-5: fifth signal output terminal (second terminal)
X: layering direction
R: instruction signal

## Claims

1. A semiconductor switch device (1) comprising:
a semiconductor switch main body unit (10) that has a plurality of semiconductor switch chips (11) and a control unit (12) which are layered;
a plurality of first terminals (20) that are connected to the semiconductor switch main body unit (10); and
a plurality of second terminals (30) that are connected to the semiconductor switch main body unit (10), the first terminals (20) and the second terminals (30) being connected via the semiconductor switch main body unit (10) and a connection state between the first terminals (20) and the second terminals (30) being changed by the semiconductor switch main body unit (10) so that a signal input from the first terminal (20) being output from any one of the second terminals (30) in a switchable manner,
wherein each of the semiconductor switch chips (11) has:
a plurality of in-chip signal lines (14, 15) that can be connected with each other;
a connection-state changing unit (13) that changes the connection state between the plurality of in-chip signal lines (14, 15) according to an instruction from the control unit (12); and
a plurality of non-contact communication units (16) that are respectively connected to the plurality of in-chip signal lines (14, 15),
wherein each of the non-contact communication units (16) of each of the semiconductor switch chips (11) communicates with the non-contact communication units (16) of one or more other semiconductor switch chips (11) in a non-contact manner in a layering direction,
wherein, in any given semiconductor switch chip (11), the first terminal (20) and the second terminal (30) are connected to any given in-chip signal line (14, 15), and
wherein the connection-state changing unit (13) of each semiconductor switch chip (11) changes the connection state between the plurality of in-chip signal lines (14, 15) according to the instruction from the control unit (12), so that the connection state between the plurality of first terminals (20) and the plurality of second terminals (30) is changed.

2. The semiconductor switch device according to claim 1, wherein one of the non-contact communication units (16) of any given semiconductor switch chip (11) communicates, in a non-contact manner in the layering direction, with a non-contact communication unit (16) of another semiconductor switch chip (11) adjacent in the layering direction, the one of the non-contact communication units (16) of the any given semiconductor switch chip (11) being disposed to overlap in the layering direction with the non-contact communication unit (16) of the another semiconductor switch chip (11).

3. The semiconductor switch device according to claim 1, wherein one of the non-contact communication units (16) of any given semiconductor switch chip (11) communicates, in a non-contact manner in the layering direction, with a non-contact communication unit (16) of another semiconductor switch chip (11) that is not adjacent in the layering direction, the one of the non-contact communication units (16) of the any given semiconductor switch chip (11) being disposed to overlap in the layering direction with the non-contact communication unit (16) of the another semiconductor switch chip (11).

4. The semiconductor switch device according to claim 3, wherein one of the non-contact communication units (16) of any given semiconductor switch chip (11) and one of the non-contact communication units (16) of at least another semiconductor switch chip (11) adjacent in the layering direction do not overlap each other in the layering direction.

5. The semiconductor switch device according to claim 1, wherein in the semiconductor switch chip (11), one of the non-contact communication units (16) are arranged to overlap the connection-state changing unit (13) in the layering direction.

6. The semiconductor switch device according to any one of claims 1 to 5, wherein the non-contact communication unit (16) is a coil.

7. The semiconductor switch device according to claim 1, wherein one of the non-contact communication units (16) of any given semiconductor switch chip (11) is an adjacent non-contact communication coil that communicates, in a non-contact manner in the layering direction, with a non-contact communication unit (16) of another semiconductor switch chip (11) adjacent in the layering direction, the one of the non-contact communication units (16) of the any given semiconductor switch chip (11) being disposed to overlap in the layering direction with the non-contact communication unit (16) of the another semiconductor switch chip (11),
another of the non-contact communication units (16) of any given semiconductor switch chip (11) is a non-adjacent non-contact communication coil that communicates, in a non-contact manner in the layering direction, with a non-contact communication unit (16) of another semiconductor switch chip (11) that is not adjacent in the layering direction, the one of the non-contact communication units (16) of the any given semiconductor switch chip (11) being disposed to overlap in the layering direction with the non-contact communication unit (16) of the another semiconductor switch chip (11), and
the size of the adjacent non-contact communication coil is smaller than the size of the non-adjacent non-contact communication coil.

8. The semiconductor switch device according to claim 1, wherein each of the semiconductor switch chip (11) is connected with one of the first terminals (20) and one of the second terminals (30).

## Patentansprüche

1. Halbleiterschaltvorrichtung (1), umfassend:
eine Halbleiterschalter-Hauptkörpereinheit (10), die mehrere Halbleiterschalterchips (11) und eine Steuereinheit (12) aufweist, die geschichtet sind; eine Vielzahl von ersten Anschlüssen (20), die mit der Halbleiterschalter-Hauptkörpereinheit (10) verbunden sind; und mehrere zweite Anschlüsse (30), die mit der Halbleiterschalter-Hauptkörpereinheit (10) verbunden sind, wobei die ersten Anschlüsse (20) und die zweiten Anschlüsse (30) über die Halbleiterschalter-Hauptkörpereinheit (10) verbunden sind und ein Verbindungszustand zwischen den ersten Anschlüssen (20) und den zweiten Anschlüssen (30) durch die Halbleiterschalter-Hauptkörpereinheit (10) geändert wird, so dass ein von dem ersten Anschluss (20) eingegebenes Signal von einem der zweiten Anschlüsse (30) umschaltbar ausgegeben wird, wobei jeder der Halbleiterschalterchips (11) aufweist:
eine Vielzahl von chipinternen Signalleitungen (14, 15), die miteinander verbunden werden können;
eine Verbindungszustandsänderungseinheit (13), die den Verbindungszustand zwischen der Vielzahl von chipinternen Signalleitungen (14, 15) gemäß einem Befehl von der Steuereinheit (12) ändert; und
eine Vielzahl von kontaktlosen Kommunikationseinheiten (16), die jeweils mit der Vielzahl von chipinternen Signalleitungen (14, 15) verbunden sind, wobei jede der kontaktlosen Kommunikationseinheiten (16) eines jeden der Halbleiterschalterchips (11) kontaktlos mit den kontaktlosen Kommunikationseinheiten (16) eines oder mehrerer anderer Halbleiterschalterchips (11) in einer Schichtrichtung kommuniziert, wobei in jedem beliebigen Halbleiterschalterchip (11) der erste Anschluss (20) und der zweite Anschluss (30) mit einer beliebigen chipinternen Signalleitung (14, 15) verbunden sind, und wobei die Verbindungszustandsänderungseinheit (13) eines jeden Halbleiterschalterchips (11) den Verbindungszustand zwischen der Vielzahl von chipinternen Signalleitungen (14, 15) gemäß dem Befehl von der Steuereinheit (12) ändert, so dass der Verbindungszustand zwischen der Vielzahl von ersten Anschlüssen (20) und der Vielzahl von zweiten Anschlüssen (30) geändert wird .

2. Halbleiterschaltvorrichtung nach Anspruch 1, wobei eine der kontaktlosen Kommunikationseinheiten (16) eines beliebigen Halbleiterschaltchips (11) in der Schichtrichtung kontaktlos mit einer kontaktlosen Kommunikationseinheit (16) eines anderen Halbleiterschaltchips (11), der in der Schichtrichtung benachbart ist, kommuniziert, wobei die eine der kontaktlosen Kommunikationseinheiten (16) des einen beliebigen Halbleiterschaltchips (11) so angeordnet ist, dass sie sich in der Schichtrichtung mit der kontaktlosen Kommunikationseinheit (16) des anderen Halbleiterschaltchips (11) überlappt.

3. Halbleiterschaltvorrichtung nach Anspruch 1, wobei eine der kontaktlosen Kommunikationseinheiten (16) eines beliebigen Halbleiterschaltchips (11) in der Schichtrichtung kontaktlos mit einer kontaktlosen Kommunikationseinheit (16) eines anderen Halbleiterschaltchips (11), der in Schichtrichtung nicht benachbart ist, kommuniziert, wobei die eine der kontaktlosen Kommunikationseinheiten (16) eines beliebigen Halbleiterschaltchips (11) in der Schichtrichtung mit der kontaktlosen Kommunikationseinheit (16) des anderen Halbleiterschalterchips (11) überlappend angeordnet ist.

4. Halbleiterschaltvorrichtung nach Anspruch 3, wobei eine der kontaktlosen Kommunikationseinheiten (16) eines beliebigen Halbleiterschalterchips (11) und eine der kontaktlosen Kommunikationseinheiten (16) mindestens eines anderen, in der Schichtrichtung benachbarten Halbleiterschalterchips (11) sich in Schichtrichtung nicht überlappen.

5. Halbleiterschaltvorrichtung nach Anspruch 1, wobei in dem Halbleiterschaltchip (11) eine der kontaktlosen Kommunikationseinheiten (16) angeordnet ist, um die Verbindungszustandsänderungseinheit (13) in der Schichtrichtung zu überlappen.

6. Halbleiterschaltvorrichtung nach einem der Ansprüche 1 bis 5, wobei die kontaktlose Kommunikationseinheit (16) eine Spule ist.

7. Halbleiterschaltvorrichtung nach Anspruch 1, wobei eine der kontaktlosen Kommunikationseinheiten (16) eines beliebigen Halbleiterschaltchips (11) eine benachbarte, kontaktlose Kommunikationsspule ist, die kontaktlos in der Schichtrichtung mit einer kontaktlosen Kommunikationseinheit (16) eines anderen in der Schichtrichtung benachbarten Halbleiterschaltchips (11) kommuniziert, wobei die eine der kontaktlosen Kommunikationseinheiten (16) des einen beliebigen Halbleiterschaltchips (11) angeordnet ist, um sich in der Schichtrichtung mit der kontaktlosen Kommunikationseinheit (16) des anderen Halbleiterschaltchips (11) zu überlappen, wobei eine andere der kontaktlosen Kommunikationseinheiten (16) eines beliebigen Halbleiterschaltchips (11) eine nicht benachbarte, kontaktlose Kommunikationsspule ist, die kontaktlos in der Schichtrichtung mit einer kontaktlosen Kommunikationseinheit (16) eines anderen, in der Schichtrichtung nicht benachbarten Halbleiterschalterchips (11) kommuniziert, wobei die eine der kontaktlosen Kommunikationseinheiten (16) des einen beliebigen Halbleiterschalterchips (11) so angeordnet ist, dass sie sich in der Schichtrichtung mit der kontaktlosen Kommunikationseinheit (16) des anderen Halbleiterschalterchips (11) überlappt, und die Größe der benachbarten kontaktlosen Kommunikationsspule kleiner ist als die Größe der nicht benachbarten kontaktlosen Kommunikationsspule.

8. Halbleiterschaltvorrichtung nach Anspruch 1, wobei jeder der Halbleiterschaltchips (11) mit einem der ersten Anschlüsse (20) und einem der zweiten Anschlüsse (30) verbunden ist.

## Revendications

1. Dispositif commutateur à semi-conducteurs (1) comprenant :
une unité de corps principal de commutateur à semi-conducteurs (10) qui comporte une pluralité de puces de commutation à semi-conducteurs (11) et une unité de commande (12) qui sont disposées en couches ;
une pluralité de premières bornes (20) qui sont connectées à l'unité de corps principal de commutateur à semi-conducteurs (10) ; et
une pluralité de secondes bornes (30) qui sont connectées à l'unité de corps principal de commutateur à semi-conducteurs (10), les premières bornes (20) et les secondes bornes (30) étant connectées via l'unité de corps principal de commutateur à semi-conducteurs (10) et un état de connexion entre les premières bornes (20) et les secondes bornes (30) étant changé par l'unité de corps principal de commutateur à semi-conducteurs (10) de telle sorte qu'un signal entré depuis la première borne (20) est sorti depuis l'une quelconque des secondes bornes (30) d'une manière commutable,
dans lequel chacune des puces de commutation à semi-conducteurs (11) comporte :
une pluralité de lignes de signal intégrées à la puce (14, 15) qui peuvent être connectées entre elles ;
une unité de changement d'état de connexion (13) qui change l'état de connexion entre la pluralité de lignes de signal intégrées à la puce (14, 15) selon une instruction provenant de l'unité de commande (12) ; et
une pluralité d'unités de communication sans contact (16) qui sont respectivement connectées à la pluralité de lignes de signal intégrées à la puce (14, 15),
dans lequel chacune des unités de communication sans contact (16) de chacune des puces de commutation à semi-conducteurs (11) communique avec les unités de communication sans contact (16) d'une ou de plusieurs autres puces de commutation à semi-conducteurs (11) sans contact dans une direction de disposition en couches,
dans lequel, dans toute puce de commutation à semi-conducteurs (11) donnée, la première borne (20) et la seconde borne (30) sont connectées à toute ligne de signal intégrée à la puce (14, 15) donnée, et
dans lequel l'unité de changement d'état de connexion (13) de chaque puce de commutation à semi-conducteurs (11) change l'état de connexion entre la pluralité de lignes de signal intégrées à la puce (14, 15) selon l'instruction provenant de l'unité de commande (12), de telle sorte que l'état de connexion entre la pluralité de premières bornes (20) et la pluralité de secondes bornes (30) est changé.

2. Dispositif commutateur à semi-conducteurs selon la revendication 1, dans lequel l'une des unités de communication sans contact (16) de toute puce de commutation à semi-conducteurs (11) donnée communique, sans contact dans la direction de disposition en couches, avec une unité de communication sans contact (16) d'une autre puce de commutation à semi-conducteurs (11) adjacente dans la direction de disposition en couches, la une des unités de communication sans contact (16) de la toute puce de commutation à semi-conducteurs (11) donnée étant disposée pour chevaucher, dans la direction de disposition en couches, l'unité de communication sans contact (16) de l'autre puce de commutation à semi-conducteurs (11).

3. Dispositif commutateur à semi-conducteurs selon la revendication 1, dans lequel l'une des unités de communication sans contact (16) de toute puce de commutation à semi-conducteurs (11) donnée communique, sans contact dans la direction de disposition en couches, avec une unité de communication sans contact (16) d'une autre puce de commutation à semi-conducteurs (11) qui n'est pas adjacente dans la direction de disposition en couches, la une des unités de communication sans contact (16) de la toute puce de commutation à semi-conducteurs (11) donnée étant disposée pour chevaucher, dans la direction de disposition en couches, l'unité de communication sans contact (16) de l'autre puce de commutation à semi-conducteurs (11).

4. Dispositif commutateur à semi-conducteurs selon la revendication 3, dans lequel l'une des unités de communication sans contact (16) de toute puce de commutation à semi-conducteurs (11) donnée et l'une des unités de communication sans contact (16) d'au moins une autre puce de commutation à semi-conducteurs (11) adjacente dans la direction de disposition en couches ne se chevauchent pas dans la direction de disposition en couches.

5. Dispositif commutateur à semi-conducteurs selon la revendication 1, dans lequel dans la puce de commutation à semi-conducteurs (11), l'une des unités de communication sans contact (16) est agencée pour chevaucher l'unité de changement d'état de connexion (13) dans la direction de disposition en couches.

6. Dispositif commutateur à semi-conducteurs selon l'une quelconque des revendications 1 à 5, dans lequel l'unité de communication sans contact (16) est une bobine.

7. Dispositif commutateur à semi-conducteurs selon la revendication 1, dans lequel l'une des unités de communication sans contact (16) de toute puce de commutation à semi-conducteurs (11) donnée est une bobine de communication sans contact adjacente qui communique, sans contact dans la direction de disposition en couches, avec une unité de communication sans contact (16) d'une autre puce de commutation à semi-conducteurs (11) adjacente dans la direction de disposition en couches, la une des unités de communication sans contact (16) de la toute puce de commutation à semi-conducteurs (11) donnée étant disposée pour chevaucher, dans la direction de disposition en couches, l'unité de communication sans contact (16) de l'autre puce de commutation à semi-conducteurs (11),
une autre des unités de communication sans contact (16) de toute puce de commutation à semi-conducteurs (11) donnée est une bobine de communication sans contact non adjacente qui communique, sans contact dans la direction de disposition en couches, avec une unité de communication sans contact (16) d'une autre puce de commutation à semi-conducteurs (11) qui n'est pas adjacente dans la direction de disposition en couches, la une des unités de communication sans contact (16) de la toute puce de commutation à semi-conducteurs (11) donnée étant disposée pour chevaucher, dans la direction de disposition en couches, l'unité de communication sans contact (16) de l'autre puce de commutation à semi-conducteurs (11), et
la taille de la bobine de communication sans contact adjacente est plus petite que la taille de la bobine de communication sans contact non adjacente.

8. Dispositif commutateur à semi-conducteurs selon la revendication 1, dans lequel chacune des puces de commutation à semi-conducteurs (11) est connectée à l'une des premières bornes (20) et à l'une des secondes bornes (30).
